# FASCICULE DE BREVET EUROPEEN

(11) **EP 2 326 004 B1**
(45) Date de publication et mention de la délivrance du brevet: **14.03.2012**
(21) Numéro de dépôt: 10190702.0
(22) Date de dépôt: 10.11.2010
(51) Int. Cl.: H03K 5/135, H03K 5/26

(54) **Circuit de commutation d'horloges sans parasites**
Schaltung zum störungsfreien Umschalten zwischen Taktsignalen
Circuit for undisturbed clock signal switching

(30) Priorité: 13.11.2009 FR 0905472
(43) Date de publication de la demande: 25.05.2011
(73) Titulaire: Thales, 92200 Neuilly Sur Seine (FR)
(72) Inventeur: Saint Ellier, Pierre, 49400 Saumur (FR); Geairon, Sébastien, 44330 La Chapelle Heulin (FR); Commun, Pascal, 49300 Cholet (FR)
(74) Mandataire: Dudouit, Isabelle

(56) Documents cités:
- DE-A1- 10 018 190
- DE-C1- 3 346 942
- US-A- 5 524 035

## Description

La présente invention concerne un circuit de commutation entre deux horloges de fréquence différentes parmi trois fréquences disponibles en entrée. Une des trois fréquences d'entrée est supprimée par le circuit de commutation qui produit à sa sortie un basculement entre les deux autres fréquences.

Le besoin de commutation d'horloges est présent dans la conception de circuits électroniques qui nécessitent au moins deux fréquences de traitement de valeurs distinctes, par exemple une fréquence haute et une fréquence basse. Le plus souvent les circuits de commutation existants permettent de basculer entre deux signaux d'horloge de fréquences distinctes, mais de valeurs fixes F1 et F2 qui ne peuvent pas être modifiées comme décrit par example dans le document DE 100 18 190 A1. Dans le cadre d'une évolution d'un produit utilisant un tel circuit de commutation, un nouveau besoin concernant un signal d'horloge de fréquence F3 différente des deux fréquences F1 et F2 disponibles peut apparaitre. Sous la contrainte d'une réutilisation dudit circuit de commutation, le problème à résoudre concerne la mise en oeuvre d'une solution extérieure à ce circuit qui permette, à partir du signal d'horloge de fréquence F1 ou F2 et d'un troisième signal d'horloge de fréquence F3 d'effectuer une commutation entre la fréquence F1 et la fréquence F3. Cette solution de commutation doit présenter un faible encombrement et une consommation minimum et le basculement d'horloges doit se faire sans génération de parasites afin de ne pas perturber le fonctionnement du processeur qui est ensuite piloté par les fréquences F1 ou F3.

Les solutions existantes ne permettent pas, à partir d'un premier circuit de commutation entre deux horloges de fréquences F1 et F2, de remplacer la fréquence F2 par une autre fréquence F3 et d'effectuer un basculement sans parasites.

La solution proposée par l'invention consiste en un circuit de commutation d'horloges utilisant un détecteur de la fréquence F2 dont la sortie est resynchronisée par l'intermédiaire d'une bascule D et d'une porte logique NOR ou « Non-ou » en français.
A cet effet, l'invention a pour objet un circuit de commutation d'horloges comportant une première entrée destinée à recevoir un premier signal d'horloge à une fréquence alternativement égale à une première valeur F1 ou une deuxième valeur F2, une seconde entrée destinée à recevoir un deuxième signal d'horloge ,synchrone dudit premier signal d'horloge, à une troisième fréquence F3 et une sortie destinée à délivrer un troisième signal d'horloge sans parasites à une fréquence alternativement égale à ladite première valeur F1 ou ladite troisième valeur F3, caractérisé en ce que ledit circuit de commutation comporte en plus :
○ un commutateur recevant lesdits premier et deuxième signaux d'horloge et délivrant l'un ou l'autre de ces dits signaux de façon à produire ledit troisième signal d'horloge,
○ une porte logique « Non-Ou » délivrant un signal de synchronisation résultant de la fonction logique « Non-Ou » entre le dit premier signal d'horloge et ledit deuxième signal d'horloge,
o un détecteur de fréquence recevant ledit premier signal d'horloge afin de filtrer une des deux fréquences F1 ou F2 dudit signal et de produire un signal présentant un premier niveau A lorsque la fréquence dudit premier signal d'horloge est égale à F1 et un second niveau B lorsque ladite fréquence est égale à F2,
○ un circuit logique de type bascule D recevant le signal de synchronisation et le signal provenant du détecteur de fréquence et produisant un signal de commande à destination dudit commutateur pilotant la commutation entre lesdits premier et deuxième signaux d'horloge de façon à ce que ledit troisième signal d'horloge est égal :
   ■ audit premier signal d'horloge lorsque la fréquence dudit premier signal d'horloge est égale à F1
   ■ audit second signal d'horloge lorsque la fréquence dudit premier signal d'horloge est égale à F2.

Dans une variante de réalisation de l'invention, ledit détecteur de fréquence comporte au moins les composants suivants : une première résistance dont l'entrée est reliée à l'entrée dudit détecteur de fréquence, un premier condensateur connecté d'une part à ladite première résistance et d'autre part à une deuxième résistance reliée à la masse, une diode dont l'anode est reliée audit premier condensateur et la cathode est connectée à un second condensateur relié à la masse, ainsi qu'à une troisième résistance reliée à la masse et à une quatrième résistance, un transistor dont la base est connectée à ladite quatrième résistance, dont l'émetteur est relié à la masse et le collecteur est relié à une cinquième résistance alimentée par une tension continue et un couple de portes logiques NON reliées en cascade, l'entrée de la première porte logique NON étant reliée au collecteur du transistor et la sortie de la deuxième porte logique NON étant reliée à la sortie dudit détecteur de fréquence, les valeurs desdits composants étant déterminées de façon à réaliser un filtrage d'une des deux fréquences F1 ou F2 dudit premier signal d'horloge.
Dans une autre variante de réalisation de l'invention, la valeur F3 de la fréquence dudit deuxième signal d'horloge est égale au double de la deuxième valeur F2 de la fréquence dudit premier signal d'horloge.

D'autres caractéristiques apparaîtront à la lecture de la description détaillée donnée à titre d'exemple et non limitative qui suit faite en regard de dessins annexés qui représentent :
La figure 1 un synoptique du circuit de commutation selon l'invention,
La figure 2, un exemple de réalisation de la fonction de détection de fréquence mise en oeuvre dans le circuit de commutation selon l'invention,
Les figures 3 et 4, deux diagrammes représentant les chronogrammes des signaux mesurés à différents points du circuit selon l'invention.

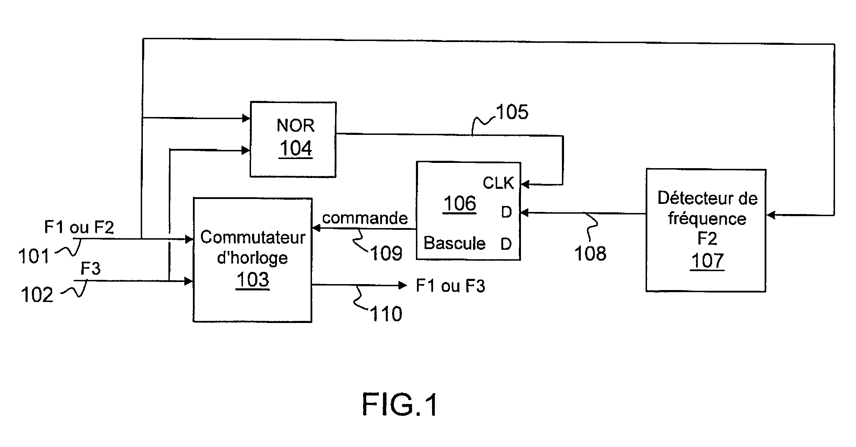

La figure 1 schématise le circuit de commutation selon l'invention. Un premier signal 101 d'horloge est injecté sur une première entrée d'un commutateur d'horloges 103. Ce premier signal 101 présente deux valeurs distinctes de fréquence d'horloge F1 et F2, par exemple une fréquence basse et une fréquence haute. A un instant donné, le signal d'horloge 101 est généré à la fréquence F1, puis à un instant ultérieur, il commute sur la fréquence F2 ou inversement. Ce signal 101 provient par exemple d'un circuit générateur d'horloges adapté à délivrer deux signaux à deux fréquences d'horloges distinctes et de commuter de l'un vers l'autre à un instant donné. Un second signal 102 d'horloge généré à une troisième fréquence F3 est injecté sur la seconde entrée du commutateur d'horloges 103. La fréquence F3 est par exemple un multiple de la fréquence F2 mais peut également adopter une valeur quelconque. Les signaux d'horloge 101 et 102 sont synchrones. La fonction du commutateur d'horloges 103 est de délivrer à sa sortie 110 un signal de fréquence F1 ou F3 et de commuter de l'un à l'autre en fonction de la consigne donnée par le signal de commande 109. La commutation d'horloges se fait, de plus, sans parasites qui pourraient perturber, par exemple, un microprocesseur piloté par le signal d'horloge 110.
Les signaux d'horloge 101,102 sont fournis en entrée d'une porte logique NOR 104 qui produit à sa sortie un signal de synchronisation 105 qui comporte un niveau haut lorsque les deux signaux d'entrée de la porte NOR 104 transitent à une valeur nulle.
Le premier signal d'horloge 101 est également fourni en entrée d'un détecteur de fréquence 107 qui a pour fonction de filtrer la fréquence F1 et de fournir en sortie un signal 108 de détection de la fréquence F2. Ce signal 108 présente un niveau élevé lorsque le signal d'horloge 101 utilise la fréquence F1 et un niveau faible lorsque ce signal 101 utilise la fréquence F2. Le détecteur de fréquence 107 met en oeuvre notamment une fonction de filtrage autour de la fréquence F1 suivie d'un redressement simple alternance et d'un second filtrage afin que seul le signal d'horloge de fréquence F1 entraine un niveau élevé sur la sortie 108 du détecteur. Cette sortie 108 est ensuite reliée à l'entrée de la bascule D 106 qui réalise une recopie du signal de sortie du détecteur de fréquence 107 vers le signal de commande 109 mais en le synchronisant à l'aide du signal de synchronisation 105.
Le commutateur d'horloges 103 délivre donc à sa sortie 110, un signal de fréquence F1 si le premier signal d'entrée 101 est de fréquence F1, et un signal de fréquence F3 si le premier signal d'entrée 101 est de fréquence F2. Le moyen utilisé pour cela est la détection de la fréquence F2.
Dans une variante de réalisation de l'invention, le détecteur de fréquence 107 peut alternativement filtrer la fréquence F2 de façon à produire en sortie 108 un signal présentant un premier niveau A lorsque la fréquence F1 est détectée et un second niveau B lorsque la fréquence F2 est détectée.

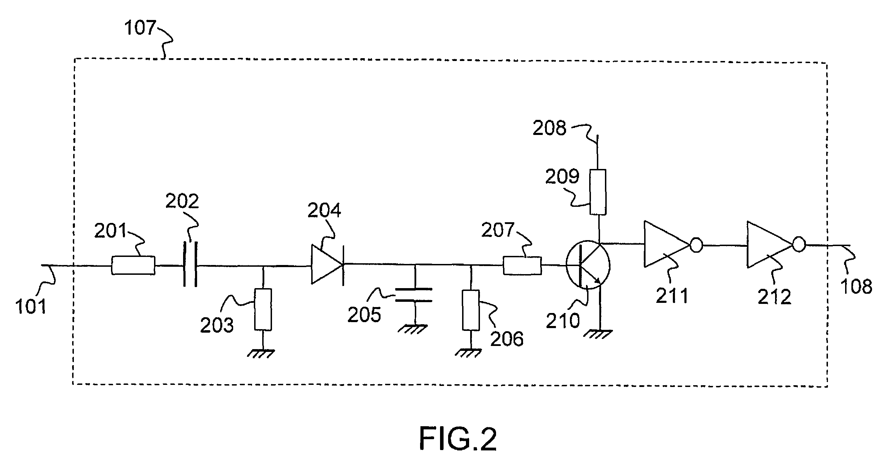

La figure 2 illustre un exemple de réalisation du détecteur de fréquences 107. La fonction de ce détecteur est de filtrer la fréquence F1 afin de produire en sortie un signal qui présente un niveau élevé lorsque le signal d'entrée 101 fonctionne à la fréquence F1 et un niveau faible lorsque la fréquence F2 est utilisée. Le but du détecteur 107 est de détecter la présence de la fréquence F2 afin d'indiquer au commutateur d'horloges 103 de commuter vers la fréquence F3 en remplacement de la fréquence F2.
Le détecteur de fréquences 107 comprend une première résistance 201 recevant en entrée le signal d'horloge 101 et reliée en sortie à un condensateur 202 lui-même relié à une deuxième résistance 203 et à une diode 204. La deuxième résistance 203 est reliée à son autre extrémité à la masse. La diode 204 est reliée à un condensateur 205 lui-même connecté à la masse, à une troisième résistance 206 également reliée à la masse et à une quatrième résistance 207 reliée à la base d'un transistor 210 dont l'émetteur est relié à la masse et le collecteur est connecté à une alimentation de tension continue 208 à travers une cinquième résistance 209. Le collecteur du transistor 210 est également relié à deux fonctions logiques NON 211,212 enchainées en cascade. Le signal 108 de détection de la fréquence F2 est délivré en sortie de la seconde fonction logique NON 212.

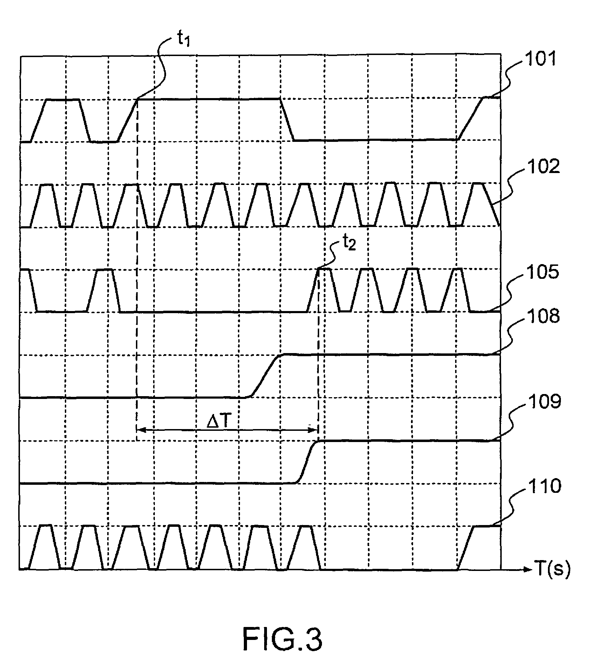

La figure 3 représente un exemple de chronogrammes des différents signaux nécessaires au fonctionnement du circuit de commutation selon l'invention tel que décrit à l'appui de la figure 1. Pour illustrer le fonctionnement dudit circuit, l'exemple de la figure 3 utilise une fréquence F1 de valeur faible, par exemple F1= 51 KHz, une fréquence F2 élevée, par exemple F2=9600 kHz et une fréquence F3 égale au double de la fréquence F2, soit F3=19200 kHz. L'exemple illustré correspond à une commutation de F3 vers F1.
Le premier signal d'horloge 101 se propage à la fréquence F2, puis à un instant t1 commute sur la fréquence F1, plus faible. Le second signal d'horloge 102 se propage constamment à la fréquence F3. Le signal de synchronisation 105 correspond à la fonction « Non-Ou » appliquée aux deux précédents signaux d'horloge, il présente donc un niveau haut lorsque les deux signaux d'horloge 101,102 présentent simultanément un niveau bas et un niveau bas dans les autres cas. Le signal 108 issu du détecteur de fréquence 107 présente un niveau bas lorsque le premier signal d'horloge 101 utilise la fréquence F2 puis un niveau haut lorsque ce dernier bascule à la fréquence F1. Le signal 109 de commande correspond à un décalage temporel d'un écart ΔT du signal 108. L'écart ΔT est dû d'une part à la latence induite par le détecteur de fréquence 107 et d'autre part au fait que le signal de commande 109 est resynchronisé par le niveau haut du signal de synchronisation 105 qui apparaît à l'instant t2. Le signal commuté 110 présente donc une fréquence F3 lorsque le premier signal d'horloge 101 présente une fréquence F2 puis ledit signal commuté 110 bascule à la fréquence F1 lorsque le signal de commande 109 bascule à un niveau haut lui indiquant par cet intermédiaire que le premier signal d'horloge 101 a lui-même basculé sur la fréquence F1.

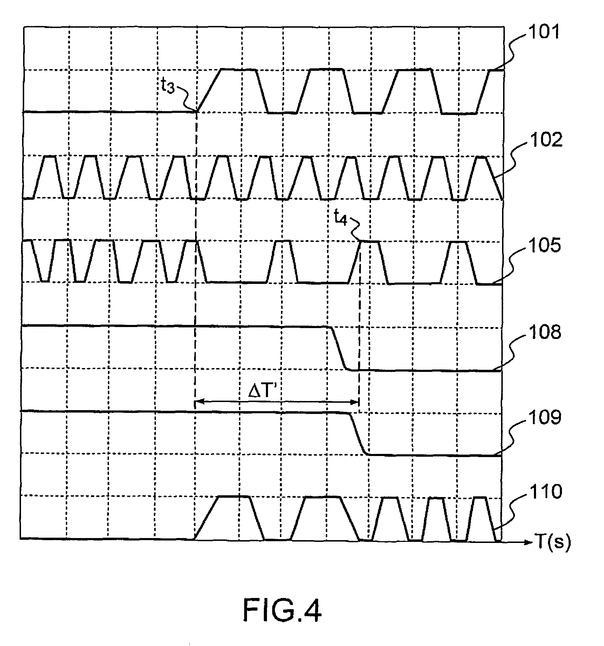

La figure 4 illustre un autre exemple de chronogrammes dans le cas d'une commutation de la fréquence F1 vers la fréquence F3.
Le premier signal d'horloge 101 bascule à un instant t3 de la fréquence F1 vers la fréquence F2. Le deuxième signal d'horloge 102 présente toujours une fréquence F3 constante égale au double de la fréquence F2. Le signal de synchronisation 105 est créé à partir de la fonction logique « Non-Ou » appliquée aux deux signaux d'horloge 101,102. Le signal 108 issu du détecteur de fréquence bascule d'un niveau haut à un niveau bas à l'instant t3. Le signal de commande 109 bascule d'un niveau haut à un niveau bas à l'instant t4 où le signal de synchronisation 105 repasse à un niveau haut pour la première fois après que la latence induite par le détecteur de fréquence 107 soit écoulée.
Le signal commuté 110 suit la valeur du premier signal d'horloge 101 jusqu'à l'instant t4 puis bascule sur la valeur du deuxième signal d'horloge 102. On note ici que la commutation de la fréquence F1 vers la fréquence F3 passe par la valeur intermédiaire F2 pendant un cours laps de temps ΔT' = t4-t3 qui correspond au temps qui s'écoule entre le basculement de la fréquence F1 à la fréquence F2 et l'instant où le signal 109 de commande passe à un niveau bas. Pendant ce temps, le commutateur d'horloges 103 délivre toujours en sortie le premier signal d'horloge 101 dont la fréquence a déjà basculé vers sa valeur F2. Ce comportement n'est pas pénalisant car la latence induite par le détecteur de fréquence 107 est faible.

Dans une variante de réalisation, les signaux 108 et 109 issus du détecteur de fréquence 107 peuvent présenter des niveaux inversés à ceux mentionnés à l'appui des figures 3 et 4. Dans un cas plus général, ces deux signaux transitent d'un premier niveau A vers un second niveau B lorsqu'il y a basculement de la fréquence F1 vers F2 (ou inversement) en entrée du dispositif.

Le circuit de commutation selon l'invention présente notamment l'avantage d'être peu encombrant et peu consommateur ce qui est essentiel pour des applications embarquées dans des équipements portatifs comme par exemple un téléphone mobile.

## Revendications

1. Circuit de commutation d'horloges comportant une première entrée destinée à recevoir un premier signal d'horloge (101 ) à une fréquence alternativement égale à une première valeur F1 ou une deuxième valeur F2, une seconde entrée destinée à recevoir un deuxième signal d'horloge (102), synchrone dudit premier signal d'horloge, à une troisième fréquence F3 et une sortie destinée à délivrer un troisième signal d'horloge (110) sans parasites à une fréquence alternativement égale à ladite première valeur F1 ou à ladite troisième valeur F3, **caractérisé en ce que** ledit circuit de commutation comporte au moins:
○ un commutateur (103) recevant lesdits premier et deuxième signaux d'horloge (101,102) et délivrant l'un ou l'autre de ces dits signaux (101,102) de façon à produire ledit troisième signal d'horloge (110),
○ une porte logique « Non-Ou » (104) délivrant un signal (105) de synchronisation résultant de la fonction logique « Non-Ou » entre le dit premier signal d'horloge (101) et ledit deuxième signal d'horloge (102),
○ un détecteur de fréquence (107) recevant ledit premier signal d'horloge (101) afin de filtrer une des deux fréquences F1 ou F2 dudit signal (101) et de produire un signal (108) présentant un premier niveau A lorsque la fréquence dudit premier signal d'horloge (101) est égale à F1 et un second niveau B lorsque ladite fréquence est égale à F2,
○ un circuit logique (106) de type bascule D recevant le signal de synchronisation (105) et le signal (108) provenant du détecteur de fréquence (107) et produisant un signal de commande (109) à destination dudit commutateur (103) pilotant la commutation entre lesdits premier et deuxième signaux d'horloge (101,102) de façon à ce que ledit troisième signal d'horloge (110) soit égal :
■ audit premier signal d'horloge (101) lorsque la fréquence dudit premier signal d'horloge est égale à F1
■ audit second signal d'horloge (102) lorsque la fréquence dudit premier signal d'horloge est égale à F2.

2. Circuit de commutation d'horloges selon la revendication 1 **caractérisé en ce que** ledit détecteur de fréquence (107) comporte au moins les composants suivants : une première résistance (201) dont l'entrée est reliée à l'entrée dudit détecteur de fréquence (107), un premier condensateur (202) connecté d'une part à ladite première résistance (201) et d'autre part à une deuxième résistance (203) reliée à la masse, une diode (204) dont l'anode est reliée audit premier condensateur (202) et la cathode est connectée à un second condensateur (205) relié à la masse, ainsi qu'à une troisième résistance (206) reliée à la masse et à une quatrième résistance (207), un transistor (210) dont la base est connectée à ladite quatrième résistance (207), dont l'émetteur est relié à la masse et le collecteur est relié à une cinquième résistance (209) alimentée par une tension continue (208) et un couple de portes logiques NON (211,212) reliées en cascade, l'entrée de la première porte logique NON (211) étant reliée au collecteur du transistor (210) et la sortie de la deuxième porte logique NON (212) étant reliée à la sortie dudit détecteur de fréquence (107), les valeurs desdits composants étant déterminées de façon à réaliser un filtrage d'une des deux fréquences F1 ou F2 dudit premier signal d'horloge (101).

3. Circuit de commutation d'horloges selon l'une des revendications précédentes **caractérisé en ce que** la valeur F3 de la fréquence dudit deuxième signal d'horloge (102) est égale au double de la deuxième valeur F2 de la fréquence dudit premier signal d'horloge (101).

## Claims

1. A clock switching circuit comprising a first input designed to receive a first clock signal (101) at a frequency alternately equal to a first value F1 or a second value F2, a second input designed to receive a second clock signal (102), synchronous with said first clock signal, at a third frequency F3 and an output designed to deliver a third clock signal (110) without interference at a frequency alternately equal to said first value F1 or to said third value F3, **characterised in that** said switching circuit comprises at least:
○ a switch (103) receiving said first and second clock signals (101, 102) and delivering one or other of said signals (101, 102) so as to produce said third clock signal (110),
○ an "NOR" logic gate (104) delivering a synchronisation signal (105) that results from the "NOR" logic function between said first clock signal (101) and said second clock signal (102),
○ a frequency detector (107) receiving said first clock signal (101) so as to filter one of the two frequencies F1 or F2 of said signal (101) and to produce a signal (108) having a first level A when the frequency of said first clock signal (101) is equal to F1 and a second level B when said frequency is equal to F2,
○ a D-type flip-flop logic circuit (106) receiving the synchronisation signal (105) and the signal (108) that originates from the frequency detector (107) and producing a control signal (109) destined for said switch (103) that controls the switching between said first and second clock signals (101, 102) so that said third clock signal (110) is equal:
■ to said first clock signal (101) when the frequency of said first clock signal is equal to F1;
■ to said second clock signal (102) when the frequency of said first clock signal is equal to F2.

2. The clock switching circuit according to claim 1, **characterised in that** said frequency detector (107) comprises at least the following components: a first resistor (201), the input of which is linked to the input of said frequency detector (107), a first capacitor (202) connected on the one hand to said first resistor (201) and on the other hand to a second resistor (203) linked to the mass, a diode (204), the anode of which is linked to said first capacitor (202) and the cathode of which is connected to a second capacitor (205) linked to the mass, as well as a third resistor (206) linked to the mass and a fourth resistor (207), a transistor (210), the base of which is connected to said fourth resistor (207), the emitter of which is linked to the mass and the collector is linked to a fifth resistor (209) that is supplied with a direct voltage (208) and a pair of NOT logic gates (211, 212) linked in a cascade like manner, the input of the first NOT logic gate (211) being linked to the collector of the transistor (210) and the output of the second NOT logic gate (212) being linked to the output of said frequency detector (107), the values of said components being determined so as to carry outfiltering of one of the two frequencies F1 or F2 of said first clock signal (101).

3. The clock switching circuit according to any one of the preceding claims, **characterised in that** the value F3 of the frequency of said second clock signal (102) is equal to two times the second value F2 of the frequency of said first clock signal (101).

## Patentansprüche

1. Schaltung zum Umschalten zwischen Taktsignalen, die einen ersten Eingang aufweist, der dazu bestimmt ist, ein erstes Taktsignal (101) mit einer Frequenz zu erhalten, die alternativ gleich einem ersten Wert F1 oder einem zweiten Wert F2 ist, einen zweiten Eingang, der dazu bestimmt ist, ein zweites Taktsignal (102) zu erhalten, das mit dem ersten Taktsignal synchron ist, mit einer dritten Frequenz F3 und einen Ausgang, der dazu bestimmt ist, ein drittes störungsfreies Taktsignal (110) mit einer Frequenz auszugeben, die alternativ gleich dem ersten Wert F1 oder dem dritten Wert F3 ist, **dadurch gekennzeichnet, dass** die Schaltung zum Umschalten mindestens aufweist:
o einen Umschalter (103), der das erste und zweite Taktsignal (101,102) empfängt und das eine oder das andere dieser Signale (101,102) derart ausgibt, dass das dritte Taktsignal (110) produziert wird,
o ein logisches Verknüpfungsglied "Nein-Oder" (104), das ein Synchronisationssignal (105) als Ergebnis der logischen Funktion "Nein-Oder" zwischen dem ersten Taktsignal (101) und dem zweiten Taktsignal (102) ausgibt,
o einen Frequenzdetektor (107), der das erste Taktsignal (101) empfang, um eine der zwei Frequenzen F1 oder F2 des Signals (101) zu filtern und um ein Signal (108) zu produzieren, das ein erstes Niveau A aufweist, wenn die Frequenz des ersten Taktsignals (101) gleich F1 ist und ein zweites Niveau B, wenn die Frequenz gleich F2 ist,
○ eine logische Schaltung (106) vom Typ Flipflop D, die das Synchronisierungssignal (105) und das Signal (108) vom Frequenzdetektor (107) empfängt und ein Steuersignal (109) produziert in Richtung des Umschalters (103), der die Umschaltung zwischen dem ersten und zweiten Taktsignal (101,102) derart steuert, dass das dritte Taktsignal (110) gleich ist:
■ dem ersten Taktsignal (101), wenn die Frequenz des ersten Taktsignals gleich F1 ist,
■ dem zweiten Taktsignal (102), wenn die Frequenz des ersten Taktsignals gleich F2 ist.

2. Schaltung zum Umschalten zwischen Taktsignalen nach Anspruch 1, **dadurch gekennzeichnet, dass** der Frequenzdetektor (107) mindestens die folgenden Bauteile aufweist: einen ersten Widerstand (201), dessen Eingang mit dem Eingang des Frequenzdetektors (107) verbunden ist, einen ersten Kondensator (202), der einerseits an den ersten Widerstand (201) und andererseits an einen zweiten Widerstand (203) angeschlossen ist, der mit der Masse verbunden ist, eine Diode (204), deren Anode mit dem ersten Kondensator (202) verbunden ist und deren Kathode an einen zweiten Kondensator (205) angeschlossen ist, der mit der Masse verbunden ist sowie mit einem dritten Widerstand (206), der mit der Masse und mit einem vierten Widerstand (207) verbunden ist, einen Transistor (210), dessen Basis an den vierten Widerstand (207) angeschlossen ist, dessen Sender mit der Masse verbunden ist und wobei der Kollektor mit einem fünften Widerstand (209) verbunden ist, der von einer Gleichspannung (208) versorgt wird und ein Paar logischer Verknüpfungsglieder NON (211, 212), die als Kaskade verbunden sind, wobei der Eingang des ersten logischen Verknüpfungsglieds NON (211) mit dem Kollektor des Transistors (210) verbunden ist und der Ausgang des zweiten logischen Verknüpfungsglieds NON (212) mit dem Ausgang des Frequenzdetektors (107) verbunden ist, wobei die Werte der Bauteile derart bestimmt sind, dass eine Filterung einer der zwei Frequenzen F1 oder F2 des ersten Taktsignals (101) durchgeführt wird.

3. Schaltung zum Umschalten zwischen Taktsignalen nach einem der vorangehenden Ansprüche, **dadurch gekennzeichnet, dass** der Wert F3 der Frequenz des zweiten Taktsignals (102) gleich dem Doppelten des zweiten Werts F2 der Frequenz des ersten Taktsignals (101) ist.
